# FASCICULE DE BREVET EUROPEEN

(11) **EP 3 550 622 B1**
(45) Date de publication et mention de la délivrance du brevet: **20.05.2020**
(21) Numéro de dépôt: 19165354.2
(22) Date de dépôt: 26.03.2019
(51) Int. Cl.: H01L 45/00, H01L 27/24

(54) **CIRCUIT INTÉGRÉ À TRANSISTORS BIPOLAIRES**
INTEGRIERTER SCHALTKREIS MIT BIPOLAREN TRANSISTOREN
INTEGRATED CIRCUIT WITH BIPOLAR TRANSISTORS

(30) Priorité: 06.04.2018 FR 1853043
(43) Date de publication de la demande: 09.10.2019
(73) Titulaire: STMicroelectronics (Crolles 2) SAS, 38920 Crolles (FR); STMicroelectronics (Rousset) SAS, 13790 Rousset (FR)
(72) Inventeur: BOIVIN, Philippe, 13770 Venelles (FR); FAGOT, Jean-Jacques, 13790 Rousset (FR); PETITPREZ, Emmanuel, 38100 Grenoble (FR); SOUCHIER, Emeline, 38330 Saint-Ismier (FR); WEBER, Olivier, 38000 Grenoble (FR)
(74) Mandataire: Cabinet Beaumont

(56) Documents cités:
- JP-A- 2005 026 392
- US-A1- 2012 099 363
- US-B1- 7 847 374

## Description

### Domaine

La présente demande concerne les circuits intégrés et plus particulièrement les connexions de transistors bipolaires. La présente demande s'applique plus particulièrement à la réalisation d'une matrice de points mémoire.

### Exposé de l'art antérieur

Les mémoires sont généralement sous forme de matrices, comprenant des lignes de mot ("wordline"), et des colonnes, ou lignes de bit ("bitline"). Un point mémoire contenant une information binaire se situe à chaque croisement d'une ligne de mot et d'une ligne de bit.

Dans une mémoire à changement de phase, chaque point mémoire comprend une couche de matériau à changement de phase dont la partie inférieure est en contact avec un élément résistif. Les matériaux à changement de phase sont des matériaux qui peuvent basculer d'une phase cristalline à une phase amorphe et inversement. Ce basculement est provoqué par une augmentation de la température de l'élément résistif dans lequel on fait passer un courant électrique. La différence de résistance électrique entre la phase amorphe du matériau et sa phase cristalline est utilisée pour définir deux états de mémoire, par exemple 0 et 1.

Dans l'exemple d'une mémoire à changement de phase, les points mémoire sont par exemple commandés par des transistors bipolaires qui font passer, ou non, le courant servant à chauffer les éléments résistifs. Les points mémoire appartenant à une même ligne de bit sont connectés par un conducteur recouvrant le matériau à changement de phase et les points mémoire appartenant à une même ligne de mot sont connectés ensemble par les bases des transistors bipolaires, par exemple par une base commune à tous les transistors d'une même ligne de mot. Un exemple de l'art antérieur s'est trouve dans le brevet JP2005/026392.

L'information binaire d'un point mémoire d'une mémoire à changement de phase est par exemple accédée en mesurant la résistance entre la ligne de bit et la ligne de mot du point mémoire.

### Résumé

Ainsi, un mode de réalisation prévoit un circuit intégré comprenant : une ligne de transistors bipolaires avec une base commune, la base commune étant située entre des premières et secondes régions constituant des bornes de conduction ; une tranchée isolante, parallèle et en contact avec la ligne de transistors ; et un peigne en matériau conducteur contactant avec la base et étant situé entre les premières régions et en regard de la tranchée isolante, le peigne étant séparé des premières régions par des espaceurs.

Selon un mode de réalisation, le matériau conducteur est du silicium polycristallin.

Selon un mode de réalisation, le peigne est séparé de la base commune par une couche d'un premier métal.

Selon un mode de réalisation, le matériau conducteur est un deuxième métal.

Selon un mode de réalisation, chaque transistor commande un point mémoire d'une mémoire à changement de phase.

Selon un mode de réalisation, le peigne est connecté par un seul via à un réseau d'interconnexion.

Selon un mode de réalisation, la première région de chaque transistor est formée sur la base, la base étant formée sur les secondes régions.

Selon un mode de réalisation, les transistors de la ligne ont une seconde région commune.

Selon un mode de réalisation, au moins certaines parties du peigne sont recouvertes de bandes isolantes et de bandes de silicium polycristallin.

Un autre mode de réalisation prévoit un procédé de fabrication de transistors bipolaires comprenant les étapes suivantes : a) former une ligne de transistors bipolaires ayant une base commune, la base commune étant située entre des premières et secondes régions constituant des bornes de conduction, les premières régions étant séparées les unes des autres par des murs d'isolant, une tranchée isolante étant située parallèlement et en contact avec la ligne de transistors ; b) former une cavité s'étendant dans la direction de la ligne de transistors le long des premières régions et s'étendant partiellement entre chaque couple de premières régions voisines ; c) former des espaceurs sur toutes les parois de la cavité ; et d) remplir la cavité de matériau conducteur.

Selon un mode de réalisation, l'étape b) comprend la formation d'un masque de gravure, le masque de gravure comprenant des bandes s'étendant dans la direction de la ligne de transistors et s'étendant en partie sur les premières régions, en partie sur les murs d'isolant et en partie sur la tranchée isolante.

Selon un mode de réalisation, le matériau conducteur est du silicium polycristallin.

Selon un mode de réalisation, une couche d'un premier métal est déposée, entre les étapes c) et d), au fond des cavités.

Selon un mode de réalisation, le matériau conducteur est en un deuxième métal.

Selon un mode de réalisation, le premier métal est du titane.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, schématique, de transistors bipolaires ayant une base commune ;
la figure 2 est une vue en perspective, schématique, d'un mode de réalisation de transistors bipolaires ;
la figure 3 est une vue de dessus, schématique, du mode de réalisation de la figure 2 ;
la figure 4 est une vue en perspective représentant une étape de fabrication du mode de réalisation des figures 2 et 3 ;
les figures 5A et 5B sont une vue en perspective et une vue de dessus représentant une autre étape de fabrication du mode de réalisation des figures 2 et 3 ;
les figures 6A à 6C sont une vue de dessus et des vues en coupe selon les plans B-B' et C-C' de la figure 6A représentant une autre étape de fabrication du mode de réalisation des figures 2 et 3 ; et
les figures 7A à 7C sont une vue de dessus et des vues en coupe selon les plans B-B' et C-C' de la figure 7A représentant une autre étape de fabrication du mode de réalisation des figures 2 et 3.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, seuls les transistors ont été représentés. Les points mémoire et les réseaux d'interconnexion auxquels ils peuvent être connectés ne sont pas détaillés.

Dans la description qui suit, lorsque l'on fait référence à des qualificatifs de position relative, tels que les termes "dessus", "dessous", "supérieur", "inférieur", etc., il est fait référence à l'orientation des éléments concernés dans les figures. Sauf précision contraire, les expressions "approximativement", et "sensiblement" signifient à 10 % près, de préférence à 5 % près.

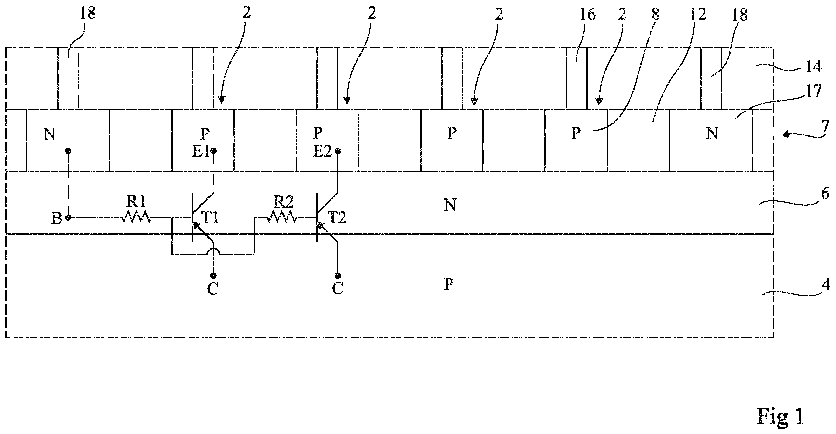

La figure 1 est une vue en coupe, schématique, d'une portion de circuit intégré comprenant quatre transistors bipolaires 2, par exemple de type PNP. Les transistors bipolaires considérés sont des transistors bipolaires verticaux, c'est-à-dire des transistors bipolaires dont les différentes parties, la base et les régions constituant les deux bornes de conduction, c'est-à-dire l'émetteur et le collecteur, sont formées les unes au-dessus des autres. On a représenté, de plus, une partie du schéma électrique équivalent.

Les transistors 2, ou T1 et T2 dans le schéma électrique équivalent, comprennent un collecteur commun 4, ou C, formé par une couche de matériau semiconducteur de type P. Les transistors 2 comprennent, de plus, une base 6, ou B, commune. La base 6 est formée par une couche de matériau semiconducteur, par exemple du silicium, de type N, recouvrant le collecteur 4. La base 6 est recouverte d'une couche 7 contenant des émetteurs 8, ou E1 et E2.

Les émetteurs 8, ou E1 et E2, sont situés sur et en contact avec la base 6. Chaque émetteur 8 est constitué par une région en matériau semiconducteur de type P, par exemple du silicium. Les émetteurs 8 sont séparés les uns des autres par des murs d'isolant 12. En figure 1, quatre émetteurs 8 sont représentés.

Une couche d'isolant 14 recouvre les émetteurs 8 et les murs 12. Des vias 16 traversent la couche d'isolant 14 jusqu'aux émetteurs 8, de manière à les relier avec des éléments non représentés. Les vias 16 relient par exemple les émetteurs 8 avec des niveaux de métallisations d'un réseau d'interconnexion. Les vias 16 peuvent aussi relier les émetteurs 8 à du matériau à changement de phase par l'intermédiaire d'éléments résistifs, de manière à former des points mémoire d'une mémoire à changement de phase commandés par les transistors bipolaires 2. Les quatre transistors 2 font alors partie d'une même ligne de mot d'une mémoire.

Des régions 17 de prise de contact de la base 6 sont régulièrement réparties. Ces régions sont constituées de matériau semiconducteur de type N sur et en contact avec la base 6 et séparées des émetteurs 8 par des murs d'isolant 12. Les régions 17 sont plus fortement dopées que la base 6. Les régions 17 sont reliées par des vias 18, similaires aux vias 16, et par un réseau d'interconnexion non représenté, à une borne de connexion externe non représentée.

Dans l'exemple de la figure 1, une région 17 est formée tous les quatre émetteurs 8. En effet, il n'est pas nécessaire d'avoir autant de régions 17 que d'émetteurs 8. Comme la surface de chaque région 17 correspond au moins à la surface d'un émetteur 8, diminuer le nombre de régions 17 permet d'augmenter le nombre de transistors dans une ligne de même longueur.

Cependant, le matériau semiconducteur de la base 6, par exemple le silicium, possède une résistance relativement élevée. Il existe donc des résistances parasites, dont deux sont représentées dans le schéma électrique équivalent et sont désignées par R1 et R2, pouvant par exemple être supérieures à 1 kΩ entre deux transistors ou entre un transistor et une région 17. Cette résistance parasite est d'autant plus élevée que les émetteurs et/ou régions sont éloignés.

On souhaite, d'une part, avoir une résistance parasite identique pour tous les transistors 2, ce qui peut être obtenu en formant une région 17 pour chaque transistor, et d'autre part, diminuer la surface nécessaire pour chaque ligne de transistors, ce qui peut être obtenu en formant une unique région 17 par ligne de transistors. Une solution est de faire un compromis en formant des régions 17 régulièrement dans chaque ligne.

Cependant, la résistance entre un émetteur 8 et la région 17 la plus proche n'est alors pas identique pour tous les émetteurs 8. De plus, la présence des régions 17 limite le nombre d'émetteurs 8, et donc de points mémoire, pouvant être formés sur une ligne d'une longueur donnée.

En outre, durant la fabrication de certains composants, tels que certaines mémoires, il est préférable d'avoir une densité de silicium polycristallin qui peut ne pas être atteinte dans le cas de mémoires commandées par les transistors bipolaires de la figure 1.

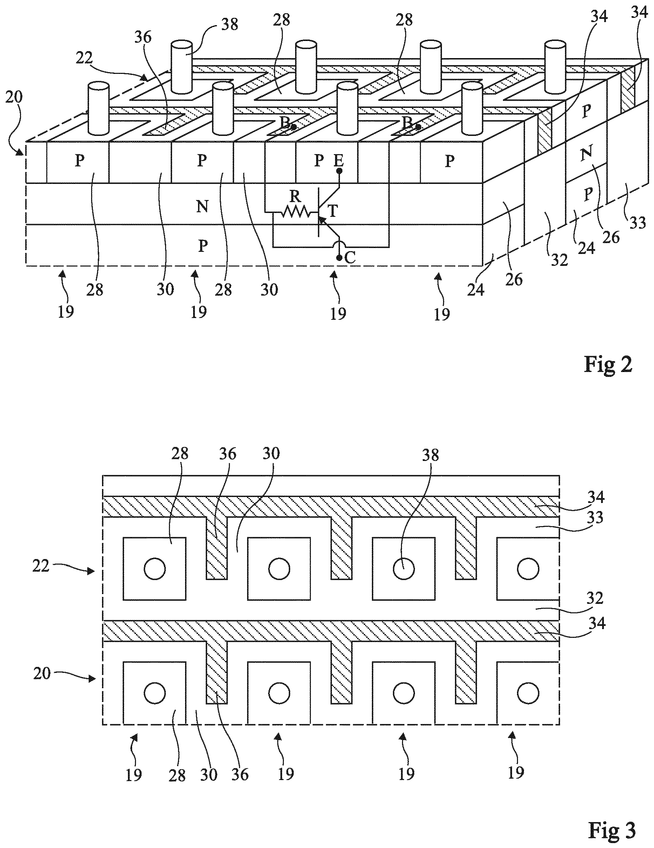

La figure 2 est une vue en perspective, schématique, d'un mode de réalisation de transistors bipolaires 19. On a aussi représenté une partie du schéma électrique équivalent représentant un transistor T et ses connexions.

La figure 3 est une vue de dessus du mode de réalisation de la figure 2.

Les figures 2 et 3 représentent une matrice de huit transistors bipolaires, séparés en deux lignes 20 et 22, comprenant chacune quatre transistors. Chaque transistor bipolaire 19 commande, par exemple, un point mémoire d'une mémoire à changement de phase. Les lignes 20 et 22 commandent alors des lignes de mot de la mémoire à changement de phase, et les colonnes de la matrice commandent des lignes de bit de la mémoire. Chaque transistor comprend une base (B) et deux régions semiconductrices constituant les bornes de conduction, émetteur (E) et collecteur (C) .

Comme cela est illustré en figure 2, chaque ligne 20 ou 22 de transistors 19 comprend une région 24 constituant un collecteur, commun à toute la ligne dans cet exemple. La région 24 est formée par une couche de matériau semiconducteur, par exemple de type P. Chaque région 24 d'une ligne 20 ou 22 est recouverte d'une base 26 commune aux transistors de cette ligne, constituée par une couche de matériau semiconducteur, par exemple de type N.

Des régions 28 en matériau semiconducteur, constituant des émetteurs et représentées en figures 2 et 3, sont formées sur et en contact avec la base 26. Chaque transistor 19 comprend, de plus, un via 38 traversant une couche d'isolant non représentée recouvrant les émetteurs 28. Les vias 38 permettent par exemple de connecter les transistors à des éléments résistifs non représentés d'une mémoire à changement de phase ou à un réseau d'interconnexion.

Les lignes de transistors bipolaires 19 sont séparées les unes des autres par des tranchées isolantes 32 et 33, par exemple en un oxyde usuel pour des tranchées isolantes ou STI (de l'anglais "Shallow Trench Isolation"), par exemple en oxyde de silicium, s'étendant dans une première direction et étant suffisamment profondes pour isoler les uns des autres les transistors 19 de lignes différentes sans pour autant traverser entièrement le substrat. Les figures 2 et 3 représentent deux tranchées isolantes 32 et 33, la tranchée 32 séparant les lignes 20 et 22 et la tranchée 33 séparant la ligne 22 d'une ligne non représentée. On considère ici que chaque tranchée isolante est associée à une ligne de transistors bipolaires parallèle et en contact avec la tranchée. La tranchée 32 est ici associée à la ligne 20 et la tranchée 33 ici est associée à la ligne 22.

Une barre conductrice principale 34 s'étend en regard de chacune des tranchées isolantes 32 et 33. Chaque barre conductrice principale 34 est par exemple suffisamment longue pour être en regard de tous les émetteurs de la ligne de transistors associée à la tranchée correspondante. Des barres conductrices auxiliaires 36 s'étendent depuis chaque barre conductrice principale 34 entre les émetteurs 28 d'une même ligne de transistors. Plus précisément, les barres auxiliaires 36 s'étendent sur une partie de la longueur des émetteurs 28. Les barres conductrices 36 s'étendent dans une seconde direction, orthogonale à la première direction. Chaque émetteur 28 d'une ligne donnée est donc séparé de chaque émetteur voisin par une barre conductrice auxiliaire 36. Les barres conductrices auxiliaires 36 prennent contact avec la base 26 commune et sont interconnectées par la barre conductrice principale 34 de manière à former un peigne. Selon un mode de réalisation, les barres conductrices principales 34 et auxiliaires 36 sont en silicium polycristallin. Selon un mode de réalisation, une couche de métal, non représentée, est intercalée entre chaque barre conductrice et la base 26 pour améliorer le contact électrique. La couche de métal est par exemple en titane. La couche de métal a par exemple une épaisseur comprise entre 1 et 20 nm. Selon un autre mode de réalisation, les barres conductrices sont entièrement en métal.

Les barres conductrices 34 et 36 sont séparées des régions 28 et des barres conductrices 34 et 36 d'autres lignes par des murs isolants 30, par exemple en oxyde de silicium. Les murs isolants comprennent en particulier des espaceurs isolants.

Chaque barre conductrice principale 34 peut être reliée à une borne de connexion extérieure non représentée par une ou plusieurs liaisons, de préférence une unique liaison pour chaque barre conductrice principale 34. Chaque liaison est faite en neutralisant un emplacement de transistor, c'est-à-dire que, bien qu'un transistor soit formé à cet emplacement, il n'est connecté à rien. Un via est ensuite formé à chacun de ces emplacements de manière à relier la barre conductrice à une borne de connexion extérieure par l'intermédiaire du réseau d'interconnexion.

Chaque émetteur 28 est séparé d'une barre conductrice auxiliaire 36, c'est-à-dire d'une prise de contact avec la base, par une partie d'un mur d'isolant 30 ayant des dimensions sensiblement égales à celles des parties de murs d'isolant situées entre d'autres émetteurs et des barres conductrices auxiliaires. La résistance parasite, désignée par R dans le schéma électrique équivalent et formée dans la base, est donc identique pour tous les transistors bipolaires 19 et est plus faible que dans l'exemple de la figure 1. Les barres conductrices principales 34 et auxiliaires 36 étant en silicium polycristallin, elles forment des résistances parasites plus faibles que celles formées dans la base entre les émetteurs 8 de la figure 1, par exemple 10 à 100 fois plus faible.

La distance séparant les émetteurs dépend du procédé de fabrication des transistors bipolaires. Avec les technologies actuelles, la distance minimale pouvant être fabriquée est d'approximativement 100 nm.

Pour les valeurs de tension utilisées dans les mémoires, par exemple un maximum de 4 V, on considère que l'épaisseur d'oxyde de silicium minimale pour une isolation correcte entre deux éléments conducteurs, c'est-à-dire par exemple les émetteurs 28 et les barres conductrices 34 et 36, est d'approximativement 10 nm.

Il est donc possible de former des barres conductrices 34 et 36, dont la largeur est par exemple comprise entre 25 et 40 nm, entre les parties de murs d'isolant 30, ayant une épaisseur supérieure à 10 nm. Les parties de murs d'isolant permettent une isolation considérée comme correcte entre les émetteurs 28 et les barres conductrices 34 et 36.

De manière plus générale, la largeur des barres conductrices 34 et 36 est choisie en fonction de la largeur des murs d'isolant 30 et de la tension qu'ils devront pouvoir isoler.

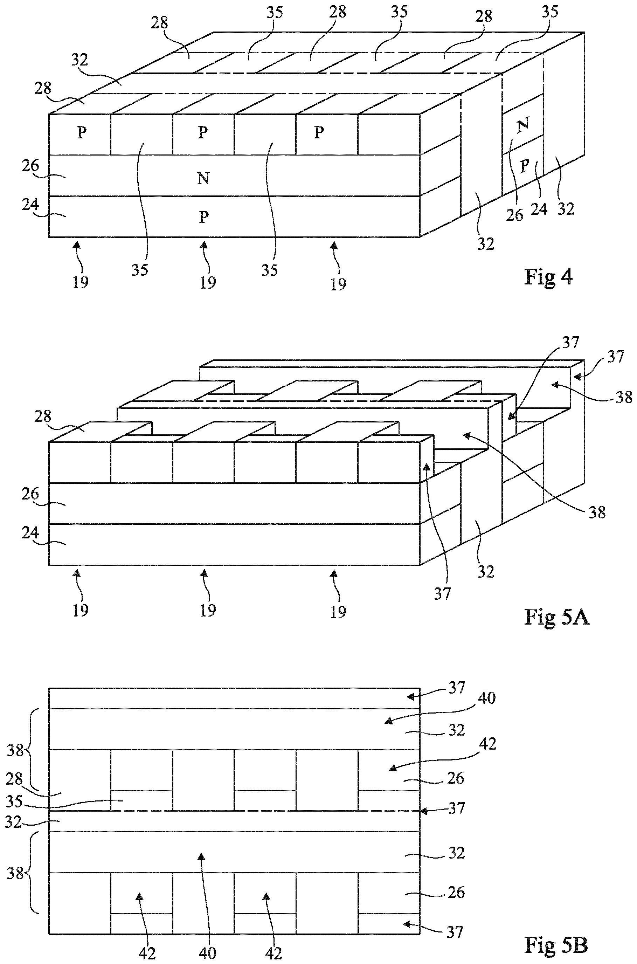

Les figures 4, 5A, 5B, 6A à 6C et 7A à 7C illustrent un procédé de fabrication de la structure représentée en figure 2.

La figure 4 illustre une étape au cours de laquelle les transistors 19, c'est-à-dire les collecteurs, bases et émetteurs, sont d'abord formés dans un substrat. Cette étape comprend la formation et le dopage des couches constituant les collecteurs 24, les bases 26 et les émetteurs 28, la formation des tranchées 32 séparant les lignes de transistors et la formation de murs d'isolant 35 séparant les émetteurs 28. Ces étapes sont par exemple effectuées par des procédés usuels de fabrication. Les transistors sont par exemple formés de manière à être les plus proches possible pour les technologies existantes. La distance entre deux émetteurs est par exemple comprise entre 80 et 150 nm.

Les figures 5A et 5B sont une vue en perspective et une vue de dessus représentant une autre étape de fabrication du mode de réalisation des figures 2 et 3.

Au cours de cette étape, un masque de gravure, non représenté, est formé. Le masque de gravure comprend une bande pour chaque ligne de transistors, chaque bande couvrant partiellement les émetteurs 28, partiellement la tranchée 32 voisine et partiellement les murs 35 voisins. Une gravure sélective est ensuite effectuée de manière à retirer l'isolant des tranchées 32 et des murs 35 dans les zones non protégées. La gravure est effectuée jusqu'à découvrir la couche 26. Le masque est ensuite retiré.

Il reste ainsi des bandes 37 de matériau isolant s'étendant en partie entre les émetteurs d'une même ligne et partiellement le long de ces émetteurs.

Des cavités 38 sont ainsi formées. Les cavités 38 ont sensiblement la forme d'un peigne, c'est-à-dire qu'elles comprennent chacune une cavité principale 40 s'étendant le long des émetteurs 28 d'une même ligne et des cavités auxiliaires 42 s'étendant chacune entre deux émetteurs 28 voisins d'une même ligne.

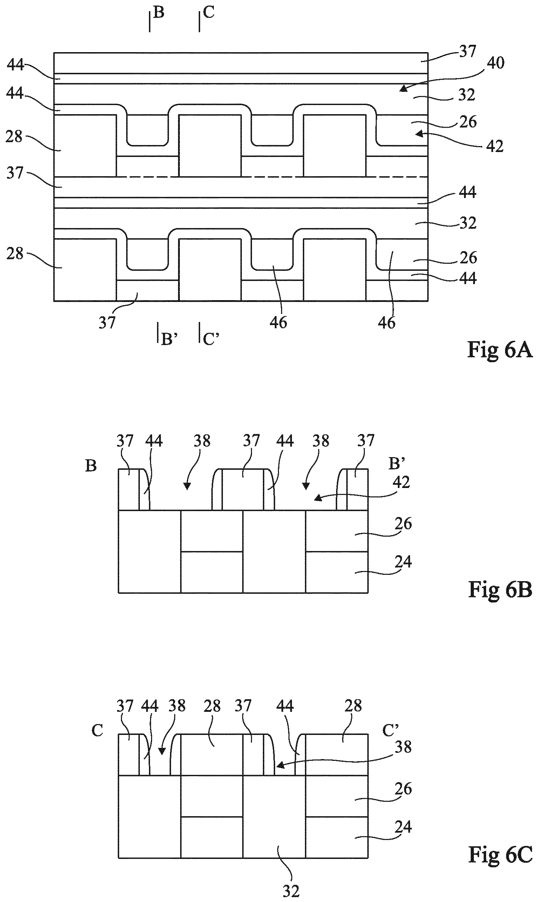

Les figures 6A à 6C sont une vue de dessus et des vues en coupe selon les plans B-B' et C-C' de la figure 6A représentant une autre étape de fabrication du mode de réalisation.

Au cours de cette étape, des espaceurs 44 sont formés sur les parois des cavités 38. Les espaceurs 44 sont par exemple en oxyde de silicium.

Les dimensions des espaceurs 44 sont suffisamment petites pour que les parties 46 découvertes de la base 26 des cavités auxiliaires 42 ne soient pas entièrement recouvertes par les espaceurs. Les parties 46 de la base 26 sont donc toujours au moins partiellement découvertes entre les émetteurs d'une même ligne de transistors. De plus, les cavités principales 40 ne sont pas entièrement remplies. Les cavités 42 d'une même ligne de transistors sont donc connectées à la cavité 40 correspondante.

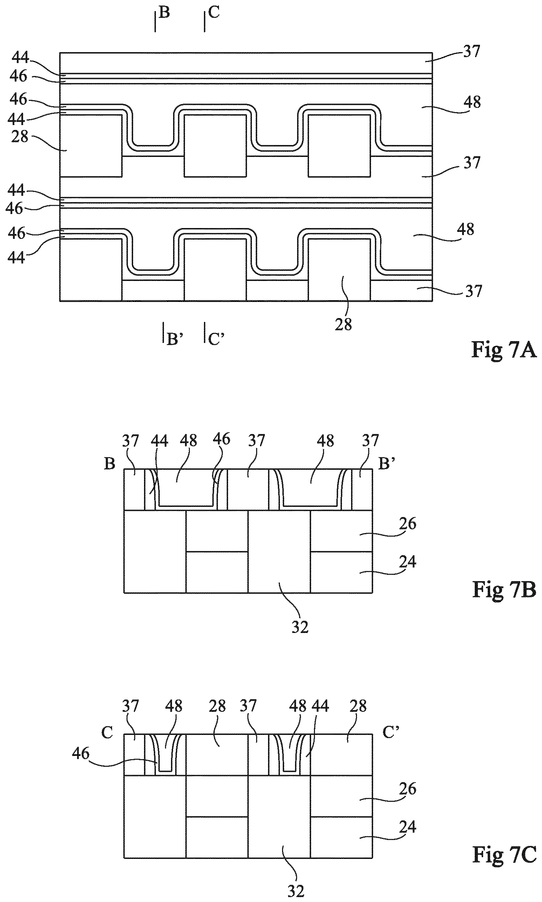

Les figures 7A à 7C sont une vue de dessus et des vues en coupe selon les plans B-B' et C-C' de la figure 7A représentant une autre étape de fabrication du mode de réalisation.

Au cours de cette étape, une couche de métal 46, par exemple du titane, est déposée sur le fond des cavités 38 et sur les espaceurs 44. Les cavités 38 sont ensuite remplies de silicium polycristallin 48 de manière à former les barres principales 34 dans les régions 40 et les barres auxiliaires 36 dans les régions 42.

A titre de variante, la couche de métal 46 peut ne pas être présente.

A titre de variante, le silicium polycristallin peut être remplacé par un métal.

On aurait pu choisir de graver directement des tranchées ayant la forme du peigne en matériau conducteur dans les murs 35 et les tranchées 32, cependant une telle gravure, avec les procédés actuels, est imprécise, particulièrement au niveau des angles. Ainsi, la gravure pourrait atteindre des émetteurs 28 et créer des contacts et donc des connexions électriques directes entre les émetteurs et les barres conductrices 34 et 36 (la base) .

La formation des espaceurs 44 après l'étape de gravure a l'avantage d'assurer la présence de matériau isolant entre les émetteurs et les barres conductrices 34 et 36.

Selon un mode de réalisation, pour augmenter la densité de silicium polycristallin, des bandes de silicium polycristallin recouvrant des bandes d'isolant peuvent être formées sur la couche comprenant les émetteurs. Ces bandes peuvent par exemple s'étendre dans la direction orthogonale à la direction des lignes de transistors (deuxième direction), sur au moins certaines des barres auxiliaires 36. Ces bandes peuvent être formées lors de la formation des isolants et des conducteurs de grille de transistors MOS.

A titre de variante, pour d'autres applications où certains transistors sont intégralement en parallèle, une barre conductrice principale 34, située dans une tranchée isolante séparant des lignes de transistors, peut interconnecter des barres conductrices auxiliaires 36 situées entre des émetteurs de deux lignes de transistors.

Un avantage des modes de réalisation décrits est que les résistances parasites entre les prises de contact de base et les différents émetteurs sont plus faibles que dans les réalisations usuelles et sont sensiblement identiques pour tous les transistors.

Un autre avantage des modes de réalisation décrits est que l'interconnexion des prises de contact avec la base, c'est-à-dire des barres conductrices auxiliaires 36, n'est pas faite à travers le réseau d'interconnexion. Il n'est donc pas nécessaire de prévoir l'espace suffisant pour une métallisation entre les métallisations du niveau inférieur du réseau d'interconnexion reliées à deux émetteurs voisins. Ainsi, la distance entre deux émetteurs ne dépend que de la résolution des masques utilisés lors de la fabrication, de l'épaisseur d'isolant permettant d'isoler correctement les tensions prévues et de l'épaisseur des barres conductrices.

Un autre avantage des modes de réalisation décrits est une augmentation de la densité de transistors et donc de points mémoire. Dans le cas où chaque ligne de mot comprend une unique connexion au réseau d'interconnexion, la longueur d'une ligne telle que celle décrite en relation avec les figures 2 et 3 est diminuée d'approximativement 35 % par rapport à une structure du type de celle de la figure 1 ayant le même nombre de transistors.

Des modes de réalisation particuliers ont été décrits. Diverses variantes et modifications apparaîtront à l'homme de l'art. En particulier, les transistors bipolaires décrits en relation avec les figures sont des transistors bipolaires PNP. Il peut cependant s'agir de transistors bipolaires NPN.

De plus, les transistors décrits dans la présente demande l'ont été dans le cadre de transistors commandant des points mémoire, et plus particulièrement des mémoires à changement de phase. Cependant, les modes de réalisation décrits peuvent aussi être mis en oeuvre pour des lignes de transistors ayant une base commune utilisées dans d'autres domaines.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Circuit intégré comprenant :
une ligne (20, 22) de transistors bipolaires (19) avec une base commune (26), la base commune étant située entre des premières (28) et secondes régions (24) constituant des bornes de conduction ;
une tranchée isolante (32), parallèle et en contact avec la ligne de transistors ; et
un peigne (34, 36) en matériau conducteur contactant avec la base et étant situé entre les premières régions et en regard de la tranchée isolante, le peigne étant séparé des premières régions par des espaceurs (44).

2. Circuit selon la revendication 1, dans lequel le matériau conducteur est du silicium polycristallin.

3. Circuit intégré selon la revendication 2, dans lequel le peigne est séparé de la base commune par une couche (46) d'un premier métal.

4. Circuit selon la revendication 1, dans lequel le matériau conducteur est un deuxième métal.

5. Circuit selon l'une quelconque des revendications 1 à 4, dans lequel chaque transistor (19) commande un point mémoire d'une mémoire à changement de phase.

6. Circuit selon l'une quelconque des revendications 1 à 5, dans lequel le peigne (34, 36) est connecté par un seul via à un réseau d'interconnexion.

7. Circuit selon l'une quelconque des revendications 1 à 6, dans lequel la première région (28) de chaque transistor est formée sur la base (26), la base étant formée sur les secondes régions (24).

8. Circuit selon l'une quelconque des revendications 1 à 7, dans lequel les transistors (19) de la ligne ont une seconde région (24) commune.

9. Circuit selon l'une quelconque des revendications 1 à 8, dans lequel au moins certaines parties du peigne sont recouvertes de bandes isolantes et de bandes de silicium polycristallin.

10. Procédé de fabrication de transistors bipolaires (19) comprenant les étapes suivantes :
a) former une ligne de transistors bipolaires ayant une base (26) commune, la base commune étant située entre des premières (28) et secondes (24) régions constituant des bornes de conduction, les premières régions étant séparées les unes des autres par des murs d'isolant (35), une tranchée isolante (32) étant située parallèlement et en contact avec la ligne de transistors (19) ;
b) former une cavité s'étendant dans la direction de la ligne de transistors le long des premières régions et s'étendant partiellement entre chaque couple de premières régions voisines ;
c) former des espaceurs (44) sur toutes les parois de la cavité (38) ; et
d) remplir la cavité de matériau conducteur.

11. Procédé selon la revendication 10, dans lequel l'étape b) comprend la formation d'un masque de gravure, le masque de gravure comprenant des bandes s'étendant dans la direction de la ligne de transistors et s'étendant en partie sur les premières régions, en partie sur les murs d'isolant et en partie sur la tranchée isolante.

12. Procédé selon la revendication 10, dans lequel le matériau conducteur est du silicium polycristallin.

13. Procédé selon l'une quelconque des revendications 10 à 12, dans lequel une couche d'un premier métal (46) est déposée, entre les étapes c) et d), au fond des cavités.

14. Procédé selon la revendication 10 ou 11, dans lequel le matériau conducteur est en un deuxième métal.

15. Circuit selon l'une quelconque des revendications 1 à 9 ou procédé selon l'une quelconque des revendications 10 à 14, dans lequel le premier métal est du titane.

## Patentansprüche

1. Integrierte Schaltung, die Folgendes aufweist:
eine Reihe (20, 22) von bipolaren Transistoren (19) mit einer gemeinsamen Basis (26), wobei die gemeinsame Basis zwischen ersten (28) und zweiten (24) Bereichen angeordnet ist, die Leitungsanschlüsse bilden;
einen isolierenden Graben (32), der parallel zu und in Kontakt mit der Transistorreihe ist; und
einen Kamm (34, 36) aus einem leitenden Material, der die Basis kontaktiert und zwischen den ersten Bereichen und gegenüber dem Isoliergraben angeordnet ist, wobei der Kamm von den ersten Bereichen durch Abstandshalter (44) getrennt ist.

2. Schaltung nach Anspruch 1, wobei das leitende Material Polysilizium ist.

3. Integrierte Schaltung nach Anspruch 2, wobei der Kamm von der gemeinsamen Basis durch eine Schicht (46) aus einem ersten Metall getrennt ist.

4. Schaltung nach Anspruch 1, wobei das leitende Material ein zweites Metall ist.

5. Schaltung nach einem der Ansprüche 1 bis 4, wobei jeder Transistor (19) eine Speicherzelle eines Phasenwechselspeichers steuert.

6. Schaltung nach einem der Ansprüche 1 bis 5, wobei der Kamm (34, 36) über ein einziges Via mit einem Verbindungsnetzwerk verbunden ist.

7. Schaltung nach einem der Ansprüche 1 bis 6, wobei der erste Bereich (28) jedes Transistors auf der Basis (26) ausgebildet ist, wobei die Basis auf den zweiten Bereichen (24) ausgebildet ist.

8. Schaltung nach einem der Ansprüche 1 bis 7, wobei die Transistoren (19) der Reihe einen zweiten gemeinsamen Bereich (24) haben.

9. Schaltung nach einem der Ansprüche 1 bis 8, wobei wenigstens bestimmte Teile des Kamms mit Isolierstreifen und mit Polysiliziumstreifen bedeckt sind.

10. Ein Verfahren zur Herstellung von bipolaren Transistoren (19), das die folgenden Schritte aufweist:
a) Ausbilden einer Reihe von bipolaren Transistoren mit einer gemeinsamen Basis (26), wobei die gemeinsame Basis zwischen ersten (28) und zweiten (24) Bereichen, die Leitungsanschlüsse bilden, angeordnet ist, wobei die ersten Bereiche durch Wände eines Isolators (35) voneinander getrennt sind, wobei ein Isoliergraben (32) parallel zu und in Kontakt mit der Reihe von Transistoren (19) angeordnet ist;
b) Ausbilden eines Hohlraums, der sich in Richtung der Transistorreihe entlang erster Bereiche erstreckt und sich teilweise zwischen jedem Paar erster benachbarter Bereiche erstreckt;
c) Ausbilden von Abstandshaltern (44) an allen Wänden des Hohlraums (38); und
d) Füllen des Hohlraums mit einem leitenden Material.

11. Verfahren nach Anspruch 10, wobei Schritt b) Das Ausbilden einer Ätzmaske aufweist, wobei die Ätzmaske Streifen aufweist, die sich in Richtung der Transistorreihe erstrecken und die sich teilweise auf den ersten Bereichen, teilweise auf den Isolatorwänden und teilweise auf dem Isoliergraben erstrecken.

12. Verfahren nach Anspruch 10, wobei das leitende Material Polysilizium ist.

13. Verfahren nach einem der Ansprüche 10 bis 12, wobei zwischen den Schritten c) und d) eine Schicht eines ersten Metalls (46) auf dem Boden der Hohlräume abgeschieden wird.

14. Verfahren nach den Ansprüchen 10 oder 11, wobei das leitende Material aus einem zweiten Metall besteht.

15. Schaltung nach einem der Ansprüche 1 bis 9 oder das Verfahren nach einem der Ansprüche 10 bis 14, wobei das erste Metall Titan ist.

## Claims

1. An integrated circuit comprising:
a row (20, 22) of bipolar transistors (19) with a common base (26), the common base being located between first (28) and second (24) regions forming conduction terminals;
an insulating trench (32), parallel to and in contact with the transistor row; and
a comb (34, 36) made of a conductive material contacting the base and being located between the first regions and opposite the insulating trench, the comb being separated from the first regions by spacers (44).

2. The circuit of claim 1, wherein the conductive material is polysilicon.

3. The integrated circuit of claim 2, wherein the comb is separated from the common base by a layer (46) of a first metal.

4. The circuit of claim 1, wherein the conductive material is a second metal.

5. The circuit of any of claims 1 to 4, wherein each transistor (19) controls a memory cell of a phase-change memory.

6. The circuit of any of claims 1 to 5, wherein the comb (34, 36) is connected by a single via to an interconnection network.

7. The circuit of any of claims 1 to 6, wherein the first region (28) of each transistor is formed on the base (26), the base being formed on the second regions (24).

8. The circuit of any of claims 1 to 7, wherein the transistors (19) of the row have a second common region (24).

9. The circuit of any of claims 1 to 8, wherein at least certain portions of the comb are covered with insulating strips and with polysilicon strips.

10. A method of manufacturing bipolar transistors (19), comprising the steps of:
a) forming a row of bipolar transistors having a common base (26), the common base being located between first (28) and second (24) regions forming conduction terminals, the first regions being separated from one another by walls of insulator (35), an insulating trench (32) being located parallel to and in contact with the row of transistors (19);
b) forming a cavity extending in the direction of the transistor row along first regions and partially extending between each pair of first neighboring regions;
c) forming spacers (44) on all the walls of the cavity (38); and
d) filling the cavity with a conductive material.

11. The method of claim 10, wherein step b) comprises the forming of an etch mask, the etch mask comprising strips extending in the direction of the transistor row and extending partly on the first regions, partly on the insulator walls, and partly on the insulating trench.

12. The method of claim 10, wherein the conductive material is polysilicon.

13. The method of any of claims 10 to 12, wherein a layer of a first metal (46) is deposited, between steps c) and d), at the bottom of the cavities.

14. The method of claim 10 or 11, wherein the conductive material is made of a second metal.

15. The circuit of any of claims 1 to 9 or the method of any of claims 10 to 14, wherein the first metal is titanium.
